# DEMANDE DE BREVET EUROPEEN

(11) **EP 4 307 503 A1**
(43) Date de publication de la demande: **17.01.2024**
(21) Numéro de dépôt: 23183957.2
(22) Date de dépôt: 06.07.2023
(51) Int. Cl.: H02G 3/10, H02G 3/14, H01R 13/46, H02G 3/12, H01R 13/516

(54) **PLAQUE D'HABILLAGE POUR APPAREILLAGE ÉLECTRIQUE ET/OU ÉLECTRONIQUE ET APPAREILLAGE COMPRENANT UNE TELLE PLAQUE D'HABILLAGE**

(30) Priorité: 10.07.2022 FR 2207068
(71) Demandeur: Legrand France, 87000 Limoges (FR); Legrand SNC, 87000 Limoges (FR)
(72) Inventeur: MOURGAUD, Jean-François, 87220 Feytiat (FR); DONNART, Guillaume, 87100 Limoges (FR)
(74) Mandataire: Jacobacci Coralis Harle

(57) **Abrégé**

L'invention concerne une plaque d'habillage (500) galbée pour un appareillage électrique et/ou électronique comprenant une plaque de finition (520) fixée sur une sous-plaque (510) portant des moyens de montage (513). Selon l'invention, la plaque de finition présente une forme massive galbée obtenue par moulage sous pression et sous chaleur d'un sandwich d'au moins trois feuilles de bois de faible épaisseur comprise entre 0,4 et 1 mm, superposées et de couches de colle insérées entre les feuilles de bois, lesdites feuilles de bois étant orientées de sorte que les fibres de bois de deux feuilles immédiatement superposées sont orientées perpendiculairement les unes aux autres, et un bord intérieur (520B) délimitant au moins une ouverture ainsi qu'un bord extérieur périphérique (520A) obtenus par des opérations de découpe.

## Description

La présente invention concerne, de manière générale, les appareillages électriques et/ou électroniques et en particulier l'habillage externe de tels appareillages.

L'invention concerne plus particulièrement une plaque d'habillage galbée pour un appareillage électrique et/ou électronique comprenant une plaque de finition fixée sur une sous-plaque portant des moyens de montage.

L'invention trouve une application particulièrement avantageuse dans la réalisation d'une plaque d'habillage avec une finition bois.

La plaque d'habillage entoure la partie fonctionnelle de l'appareillage électrique et/ou électronique. Lorsque l'appareillage est monté dans une paroi de réception, la plaque d'habillage repose sur la face avant de cette paroi de réception et masque les moyens de fixation de l'appareillage à la paroi de réception pour parfaire l'esthétique de l'ensemble. La plaque d'habillage forme aussi une protection électrique pour éviter qu'un utilisateur n'accède aux éléments de l'appareillage sous tension électrique ainsi qu'une protection étanche pour ces éléments sous tension.

La finition esthétique de l'appareillage est assurée par la plaque de finition de la plaque d'habillage fixée à la sous-plaque qui assure la protection électrique et l'étanchéité.

Actuellement, il existe plusieurs solutions techniques pour réaliser une finition bois d'une plaque d'habillage mais aucune de ces solutions ne donne entièrement satisfaction.

Une des solutions techniques consiste à usiner dans la masse une planche de bois. On connaît déjà du document US2009/0126968 un appareillage électrique avec une plaque de façade réalisée en bois. Cette plaque de façade présente des pans biseautés reliés par des arêtes. L'usinage ne permet pas d'obtenir une plaque de finition de faible épaisseur (c'est-à-dire une épaisseur inférieure ou égale à 3 mm). En outre, la plaque de finition en bois usinée accepte mal les contraintes environnementales comme les variations de température et de taux d'humidité. Ces contraintes environnementales peuvent ainsi engendrer des déformations de la plaque de finition qui nuisent à sa fixation à la sous-plaque et au bon fonctionnement de l'appareillage (la plaque de finition déformée peut bloquer l'enjoliveur qu'elle entoure et/ou engendrer des jeux inesthétiques).

Une autre solution technique consiste à réaliser un plaquage comprenant plusieurs feuilles de bois de faible épaisseur fixées directement sur la sous-plaque à l'aide d'un adhésif. Un tel plaquage ne permet pas d'obtenir une forme galbée. La plaque de finition ainsi réalisée est forcément plane. En déformant l'adhésif, on peut donner tout au plus à cette plaque de finition un très léger galbe suivant une seule direction perpendiculaire à l'orientation des fibres de bois.

Enfin, une autre solution technique consiste à décorer la face avant d'une plaque de finition réalisée en matière synthétique moulée. La décoration peut être réalisée en collant un film de décoration, en réalisant une impression numérique, en appliquant une peinture ou encore en ajoutant dans la matière synthétique des particules de bois avant son moulage. Cette solution technique ne permet pas d'obtenir une finition bois naturel.

Afin de remédier aux inconvénients de l'état de la technique précité, la présente invention propose une nouvelle plaque d'habillage de forme galbée présentant une finition bois multi-plis présentant une bonne résistance mécanique quelles que soient les contraintes environnementales auxquelles la plaque d'habillage est soumise.

Plus particulièrement, selon l'invention, il est proposé une plaque d'habillage galbée selon la revendication 1.

D'autres caractéristiques de la plaque d'habillage conforme à l'invention sont énoncées dans les revendications 2 à 10.

L'invention propose également un appareillage électrique et/ou électronique qui comprend au moins un mécanisme d'appareillage rapporté sur un support d'appareillage, un enjoliveur associé au mécanisme d'appareillage et une plaque d'habillage telle que précitée, montée sur le support d'appareillage au moyen desdits moyens de montage de la sous-plaque de sorte que ledit enjoliveur émerge en face avant dudit appareillage au travers de ladite ouverture de la plaque de finition.

La description qui va suivre en regard des dessins annexés, donnés à titre d'exemples non limitatifs, fera bien comprendre en quoi consiste l'invention et comment elle peut être réalisée.

Sur les dessins annexés :
La figure 1 est une vue schématique en coupe d'un appareillage électrique selon l'invention rapporté dans deux types différents de paroi de réception,
La figure 2 est une vue en perspective avant d'un exemple de réalisation d'un appareillage électrique selon l'invention,
La figure 3 est une vue en perspective éclatée des éléments électriques et fonctionnels de l'appareillage électrique de la figure 2,
La figure 4 est une vue de face de l'appareillage électrique de la figure 2,
La figure 5 est une vue en coupe selon le plan B-B de la figure 4,
La figure 6 est une vue en loupe du détail A de la figure 5,
La figure 7 est une représentation de principe, avant l'étape de moulage, des différentes couches du sandwich constitutif de la plaque de finition de la plaque d'habillage selon l'invention, et
La figure 8 est une représentation schématique de l'étape de moulage de la plaque de finition de la plaque d'habillage conforme à l'invention.

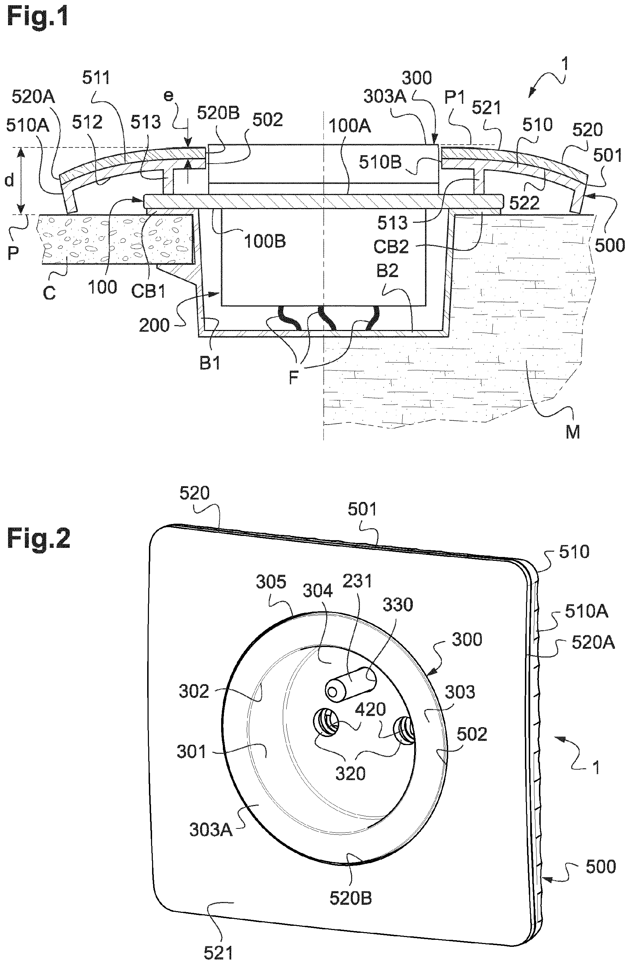

Sur la figure 1, on a représenté de façon schématique les principaux éléments structurels, fonctionnels et de décoration d'un appareillage 1 électrique et/ou électronique monté dans une ouverture d'encastrement pratiquée d'une paroi de réception.

Deux types différents de paroi de réception sont représentés sur la figure 1. Sur la moitié droite de la figure 1, la paroi de réception est un mur M maçonné et sur la moitié gauche de la figure 1, la paroi de réception est un panneau avant C d'une cloison creuse ou alvéolaire.

L'appareillage 1 est rapporté dans une boîte électrique B1 ; B2 engagée dans l'ouverture d'encastrement de la paroi de réception C; M et solidarisée à cette paroi. La boîte électrique B1 est accrochée au panneau avant C de la cloison, et la boîte électrique B2 est scellée avec un enduit ou du plâtre dans l'ouverture d'encastrement du mur M.

L'appareillage 1 comporte pour l'essentiel un mécanisme d'appareillage 200 dont le socle est engagé dans la boîte électrique B1; B2, un support d'appareillage 100 fixé à la boîte électrique B1 ; B2 et sur lequel est monté le socle du mécanisme d'appareillage 200, une partie fonctionnelle 300 associée au mécanisme d'appareillage 200, qui émerge à l'extérieur de la paroi de réception, au-dessus de la face avant 100A du support d'appareillage 100 et une plaque d'habillage 500 montée sur le support d'appareillage 100 autour de la partie fonctionnelle 300.

La face arrière 100B du support d'appareillage 100 est plaquée contre la collerette externe CB1 ; CB2 de la boîte électrique B1 ; B2 qui repose sur la face avant de la paroi de réception C ; M, autour de l'ouverture d'encastrement.

La plaque d'habillage 500 et la partie fonctionnelle 300 forment la partie avant de l'appareillage 1 accessible à l'utilisateur sur la paroi de réception C ; M.

La plaque d'habillage 500 présente une forme galbée ou courbée (convexe vers l'extérieur) suivant deux directions perpendiculaires appartenant au plan P1 dans lequel s'étend la face frontale 303A de la partie fonctionnelle 300. Elle est courbée de sorte que son bord extérieur périphérique 501 repose sur la face avant de la paroi de réception C ; M.

Avantageusement, du fait de la forme galbée de la plaque d'habillage 500 et de la manière dont elle est constituée, comme cela va être explicité ci-après dans le détail, l'épaisseur d de la partie avant de l'appareillage 1 (épaisseur mesurée entre les plans parallèles P1, P matérialisés sur la figure 1) est limitée. Ici cette épaisseur d est de l'ordre de 8 millimètres.

L'appareillage 1 peut être de tout type. Il peut s'agir d'un commutateur, d'une prise de courant fort ou faible, d'une prise téléphonique, d'un appareillage de distribution de l'information ou autre.

Sur les figures 2 à 6 on a représenté une prise de courant électrique qui constitue un exemple de réalisation de l'appareillage 1.

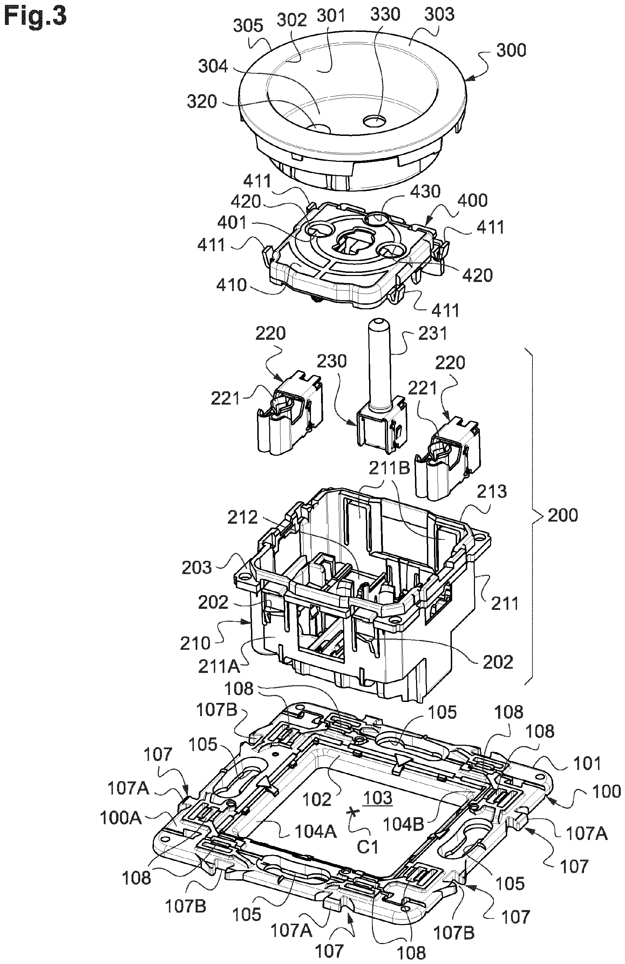

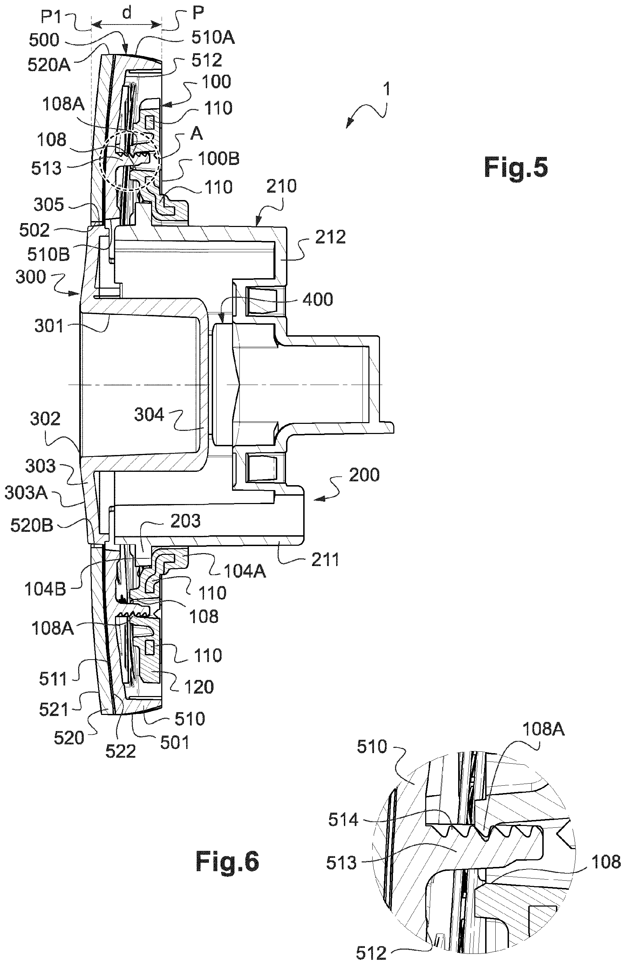

Comme le montrent plus particulièrement les figures 3 et 5, dans la prise de courant 1 représentée, le support d'appareillage 100 est un cadre plat de forme carrée. Le cadre est défini entre un bord périphérique extérieur 101 et un bord périphérique intérieur 102 qui délimite une ouverture centrale 103 également de forme carrée de centre C1.

L'ouverture centrale 103 carrée du support d'appareillage 100 accueille le socle 210, de largeur deux modules, du mécanisme d'appareillage 200 dont la façade de forme carrée remplit la surface de l'ouverture centrale 103.

Cette ouverture centrale 103 peut également accueillir deux socles un module dont chaque façade de forme rectangulaire remplit la moitié de la surface de l'ouverture centrale 103.

Pour le montage du socle 210, l'ouverture centrale 103 du support d'appareillage 100 est bordée sur ses quatre côtés de moyens de montage, ici des moyens d'encliquetage, qui comprennent un trottoir 104B et une nervure d'accrochage 104A formant un bord tombant à partir du trottoir 104B.

En correspondance, le socle 210 du mécanisme d'appareillage 200 comprend une collerette 203 qui fait saillie de la face externe de la paroi latérale 211 du socle 210 et qui longe le bord 213 de l'ouverture avant du socle 210 ainsi que quatre dents d'encliquetage 202 prévues sur la face externe de deux panneaux opposés 211A de la paroi latérale 211 du socle 210. Chaque dent d'encliquetage 202 est prévue sur une languette élastique 211B découpée dans la paroi latérale 211 du socle 210. La racine de chaque languette élastique 211B attachée à la paroi latérale 211, forme une charnière de pivotement de la languette élastique 211B pour autoriser l'accrochage et le décrochage de la dent d'encliquetage 202 correspondante sur la nervure d'accrochage 104A du support d'appareillage 100.

Le socle 210 du mécanisme d'appareillage 200 est engagé dans l'ouverture centrale 103 du support d'appareillage 100 pour que sa collerette 203 prenne appui sur le trottoir 104B du support d'appareillage 100 (voir figure 5) et que, de façon concomitante, ses dents d'encliquetage 202 s'accrochent sur le bord libre de la nervure d'accrochage 104A du support d'appareillage 100. Le support d'appareillage 100 est alors pris en sandwich par le socle 210 solidement attaché au support d'appareillage 100.

Avantageusement ici le support d'appareillage 100 comprend une âme 110 en matière métallique surmoulée d'une peau 120 en matière synthétique isolante (voir la figure 5).

La peau 120 en matière synthétique isolante recouvre la majeure partie des faces avant et arrière de l'âme 110 métallique. Elle recouvre également la tranche de cette âme.

L'âme 110 en matière métallique confère une grande rigidité au support d'appareillage 100 et la peau 120 en matière isolante confère à l'utilisateur un sentiment de sécurité électrique en formant une isolation électrique. L'association de l'âme 110 métallique et de la peau 120 surmoulée sur cette âme 110 permet d'obtenir un support d'appareillage 100 esthétique de faible épaisseur (épaisseur mesurée entre ses faces avant et arrière 100A, 100B) et de grande résistance mécanique.

Préférentiellement, la matière synthétique de la peau 120 est un polymère éventuellement chargé en fibres de verre ou un ABS (Acrylonitrile Butadiène Styrène).

Comme on peut le voir sur la figure 3, le support d'appareillage 100 comporte dans chacune de ses quatre branches des moyens d'assujettissement propres à permettre sa fixation à la boîte électrique B1; B2. Ces moyens d'assujettissement comprennent un perçage 105, en forme de trou de serrure, qui s'étend globalement circulairement, en étant centré sur le centre C1 de l'ouverture centrale 103 du support d'appareillage 100. Chaque perçage 105 permet le passage du corps fileté d'une vis de fixation (non représentée), destiné à être vissé dans un fût taraudé (non représenté) de la boîte électrique.

Par ailleurs, il est prévu dans chacune des quatre branches du support d'appareillage 100, de part et d'autre de chaque perçage 105, des moyens de clippage 108 accessibles sur la face avant 100A dudit support d'appareillage pour le clippage ou l'accrochage de la plaque d'habillage 500. Ces moyens de clippage 108 seront détaillés plus loin dans la description.

Enfin, le support d'appareillage 100 comporte sur chacun des quatre côtés de son bord périphérique extérieur 101, des moyens d'assemblage 107 à un autre support du même type.

Ici, lesdits moyens d'assemblage 107 comprennent sur chaque côté, en saillie du bord périphérique extérieur 101, un élément mâle 107A et un élément femelle 107B. Lesdits moyens d'assemblage 107 viennent de formation avec le support d'appareillage 100.

Plus particulièrement, ils comprennent sur chaque côté du bord périphérique extérieur 101, un ergot 107A et, à distance de cet ergot 107A, en correspondance avec celui-ci, une encoche 107B de contour complémentaire.

Le socle 210 du mécanisme d'appareillage 200 de la prise de courant est un boîtier isolant, de forme parallélépipédique, ouvert à l'avant. L'ouverture avant de socle 210 présente un contour carré. Elle est délimitée par le bord 213 libre du socle 210. Le socle 210 est fermé à l'arrière par une paroi de fond 212. La paroi latérale 211 et la paroi de fond 212 du socle 210 délimitent un espace intérieur au fond duquel sont logés trois bornes de connexion électrique dont deux bornes femelles 220 et une borne mâle 230. Les bornes femelles 220 sont les bornes de phase et de neutre. Elles comportent chacune un alvéole 221 pour la connexion d'une broche d'une fiche électrique non représentée. La borne mâle 230 est la borne de terre, elle porte ici la broche de terre 231 du standard Franco-Belge. Ces trois bornes de connexion électrique 220, 230 sont ici des bornes automatiques alimentées en courant par des conducteurs électriques F (représentés sur la figure 1) issus du réseau électrique. Ces conducteurs électriques F entrent dans ladite boîte électrique B1; B2 au moyen d'une gaine non représentée et sont introduits dans le socle 210 via des ouvertures (non visibles sur les figures) prévues dans une des parois du socle pour être connectés auxdites bornes 220, 230.

L'ouverture avant du socle 210 est fermée par un enjoliveur 300.

L'enjoliveur 300 forme ici le puits de la prise de courant 1 dans lequel le corps d'une fiche électrique (non représentée) peut être inséré. L'enjoliveur 300 comporte une paroi cylindrique 301 qui délimite latéralement le puits et une paroi de fond 304 percée de trois ouvertures circulaires 320, 330. Deux des ouvertures circulaires 320 se placent en regard des embouchures des alvéoles 221 des bornes femelles 220. Elles permettent le passage des broches d'une fiche électrique insérée dans le puits pour s'enficher dans les alvéoles 221 desdites bornes femelles 220. La troisième ouverture 230 est traversée par la broche de terre 231 de la borne de terre 230 qui émerge ainsi dans le puits de la prise de courant.

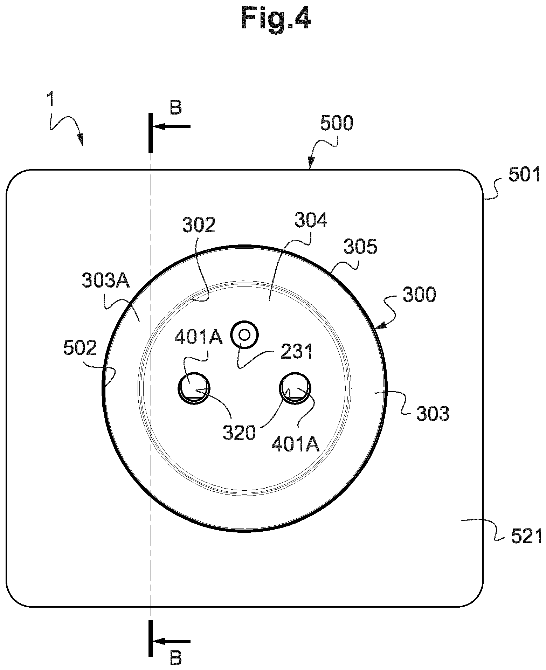

A l'avant, l'enjoliveur 300 comporte une collerette 303 annulaire qui longe le bord 302 de l'ouverture avant circulaire du puits. Cette collerette 303 s'étend vers l'extérieur du puits, en saillie de la face externe de la paroi cylindrique 301. La face avant 303A de cette collerette 303 forme la face avant de l'enjoliveur 300 (voir les figures 2 et 4). La collerette 303 porte à l'arrière des moyens de solidarisation au socle 210 lorsque l'enjoliveur 300 est inséré dans celui-ci pour fermer l'ouverture avant du socle.

Enfin, il est prévu à l'arrière de la paroi de fond 304 de l'enjoliveur 300, une cassette 400 qui enferme un volet 401 monté à rotation libre dans la cassette et assurant la sécurité électrique de la prise de courant 1 lorsque le puits est vide en attente de recevoir le corps d'une fiche électrique. Cette cassette 400 est fixée au socle 210 du mécanisme d'appareillage 200 au moyen de crochets 411 qui s'accrochent à des éléments d'accrochage complémentaires prévus sur la collerette 203. En position de repos, les pales 401A du volet 401 (visibles sur la figure 4) s'interposent entre les ouvertures circulaires 320 de la paroi de fond 304 du puits vide de l'enjoliveur 300 et les embouchures des alvéoles 221 des bornes de connexion électrique 220. Lorsqu'une fiche électrique est insérée dans le puits de l'enjoliveur 300, ses broches traversent lesdites ouvertures circulaires 320 prévues dans la paroi de fond 304 du puits et accèdent aux pales 401A du volet 401 en traversant des ouvertures adéquates 420 prévues dans le capot avant 410 de la cassette 400. Lesdites broches provoquent alors le pivotement du volet 401 vers une position d'ouverture dans laquelle les pales 401A du volet sont décalées et libèrent le passage vers les alvéoles 221 des bornes femelles 220. Ce pivotement est réalisé à l'encontre de l'action d'un moyen de rappel élastique logé dans la cassette 400 qui agit en permanence sur le volet pour le ramener vers sa position de repos. Bien entendu il est prévu dans le capot avant 410 de la cassette 400 une ouverture 430 pour le passage de la broche de terre 431. Le capot arrière de la cassette 400 comprend évidemment des ouvertures en correspondance des ouvertures 420, 430 prévues dans le capot avant 410.

Comme le montrent plus particulièrement les figures 2, 4 et 5, la plaque d'habillage 500 est rapportée sur le support d'appareillage 100 autour de l'enjoliveur 300 de la prise de courant 1. La plaque d'habillage 500 présente ici un contour externe 501 carré et une ouverture centrale circulaire dont le bord 502 longe le bord extérieur circulaire 305 de la collerette 303 de l'enjoliveur 300.

Cette plaque d'habillage 500 est avantageusement galbée et présente une finition bois naturel.

Plus particulièrement, la plaque d'habillage 500 comprend ici une plaque de finition 520 fixée sur une sous-plaque 510 portant des moyens de montage 513, 514 adaptés à coopérer avec les moyens de clippage 108 du support d'appareillage 100.

Selon une caractéristique remarquable, la plaque de finition 520 présente une forme massive galbée obtenue par moulage sous pression et sous chaleur d'un sandwich d'au moins trois feuilles de bois 523, 525, 527 de faible épaisseur comprise entre 0,4 et 1 mm, superposées et de couches de colle 524, 526 insérées entre les feuilles de bois, lesdites feuilles de bois 523, 525, 527 étant orientées de sorte que les fibres de bois de deux feuilles immédiatement superposées sont orientées perpendiculairement les unes aux autres.

L'orientation croisées à 90 degrés des fibres de bois des différentes feuilles de bois superposées permet d'augmenter la résistance mécanique de la plaque de finition 520.

La plaque de finition 520 présente un bord intérieur 520B délimitant ici une ouverture centrale ainsi qu'un bord extérieur périphérique 520A (suivant ici un contour carré correspondant au contour carré 501 de la plaque d'habillage 500) obtenus par des opérations de découpe après moulage (voir figures 1 et 2). Ces opérations de découpe sont réalisées à l'aide d'outils coupants tels qu'une fraise ou un emporte-pièce ou par laser ou encore par jet d'eau.

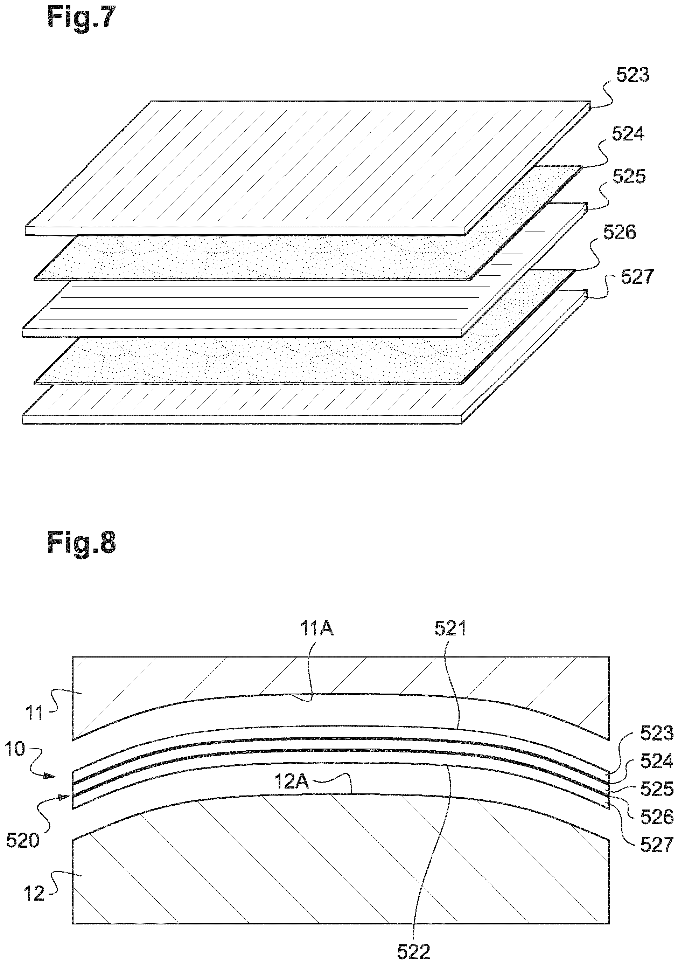

La figure 7 représente schématiquement le sandwich des feuilles de bois 523, 525, 527 et des couches de colle 524, 526 avant l'étape de moulage. Chaque feuille de bois 523, 525, 527 est une feuille de bois naturel et, préférentiellement, chaque couche de colle 524, 526 est une couche de colle à bois, préférentiellement pour usage en extérieur. Ici, toutes les feuilles de bois 523, 525, 527 présentent une épaisseur identique, préférentiellement de l'ordre de 0,5 millimètre.

Comme le montre la figure 8, le sandwich des feuilles de bois 523, 525, 527 et des couches de colle 524, 526 représenté sur la figure 7, est pressé à chaud entre les mâchoires 11, 12 d'un moule 10 dont les faces intérieures 11A, 12A en regard présentent le galbe adéquate pour obtenir la plaque de finition 520 galbée, d'une épaisseur e inférieure ou égale à 3 millimètres, avec une face avant 521 et une face arrière 522 parallèles, courbées suivant deux directions perpendiculaires, coplanaires (ces deux directions appartiennent au plan P1 formé par la face avant 303A de l'enjoliveur 300).

Lors du pressage, l'action de la chaleur accélère le collage des feuilles de bois entre elles et permet de conserver le galbe imposé au sandwich par le moule.

Avantageusement, la pression de moulage est de l'ordre de 8 à 10 Kg/cm2 et la température de moulage est comprise entre 110 et 150 degrés Celsius, préférentiellement égale à 130 degrés Celsius.

La sous-plaque 510 de la plaque d'habillage 500 est réalisée d'une seule pièce en matière plastique moulée. Elle présente le même galbe que celui de la plaque de finition 520 et une épaisseur supérieure à celle-ci de l'ordre de 5 millimètres. Elle comprend ainsi une face avant 511 et une face arrière 512 parallèles courbées selon deux directions perpendiculaires coplanaires (ces deux directions appartiennent au plan P1 formé par la face avant 303A de l'enjoliveur 300). Les faces avant et arrière 511, 512 de la sous-plaque 510 sont parallèles à celles de la plaque de finition 520. La sous-plaque 510 présente un bord intérieur 510B délimitant ici une ouverture centrale ainsi qu'un bord extérieur périphérique 510A (suivant ici un contour carré correspondant au contour carré 501 de la plaque d'habillage 500).

La sous-plaque 510 forme une base rigide sur laquelle est fixée la plaque de finition 520. La plaque de finition 520 est fixée à la sous-plaque 510 au moyen d'un adhésif double face tel qu'un acrylique modifié.

Comme le montrent les figures 1 et 5, la face arrière 522 de la plaque de finition 520 recouvre totalement et parfaitement la face avant 511 de la sous-plaque 510 si bien que la sous-plaque 510 disparaît sous la plaque de finition 520. Les bords extérieurs périphériques 520A, 510A de la plaque de finition 520 et de la sous-plaque 510 s'étendent dans le prolongement l'un de l'autre pour former le bord extérieur périphérique 501 de la plaque d'habillage 500. Les bords intérieurs 520B, 510B de la plaque de finition 520 et de la sous-plaque 510 se superposent pour former le bord 502 de l'ouverture centrale de la plaque d'habillage 500. Comme le montrent les figures 2 et 5, le bord intérieur 520B de la plaque de finition 520 longe au plus près le bord extérieur circulaire 305 de la collerette 303 de l'enjoliveur 300. La face avant 521 courbée de la plaque de finition 520 forme la face avant de la plaque d'habillage 500 et la face arrière 512 de la sous-plaque 510 forme la face arrière de la plaque d'habillage 500 qui recouvre complètement le support d'appareillage 100. La surface de la sous-plaque 510 de plaque d'habillage 500 est supérieure à celle du support d'appareillage 100 si bien que celui-ci est complètement enfermé par celle-ci. Le bord extérieur périphérique 510A de la sous-plaque 510 est destiné à s'appuyer contre la face avant de la paroi de réception de la prise de courant 1.

Avantageusement, comme le montre la figure 5, l'épaisseur d de la plaque d'habillage 500 prise entre le plan avant P1 et le plan arrière P de ladite plaque, est de l'ordre de 8 millimètres (à plus ou moins 1 millimètre près).

Comme le montrent les figures 5 et 6, les moyens de montage de la sous-plaque 510 sur le support d'appareillage 100 comprennent deux pattes 513 qui s'étendent vers l'arrière à partir de la face arrière 512 de la sous-plaque 510 et qui sont pourvues d'une série de crans 514. En correspondance, le support d'appareillage 100 comprend des moyens de clippage constitués d'ouvertures 108 pourvues sur un bord d'un cran complémentaire 108A. Chaque patte 513 de la sous-plaque 510 est engagée dans une ouverture 108 du support d'appareillage 100 de sorte que le cran complémentaire 108A de ladite ouverture 108 s'engage dans un cran 514 de la patte 513 correspondante de la sous-plaque 510 et bloque celle-ci sur le support d'appareillage 100. Avantageusement, la série de crans 514 prévue sur chaque patte 513 permet d'ajuster au mieux les positions relatives de la sous-plaque 510 et du support d'appareillage 100.

L'invention n'est pas limitée à la description détaillée et diverses autres modifications peuvent y être apportées.

Bien entendu, diverses autres modifications peuvent aussi être apportées à l'invention dans le cadre des revendications annexées.

En particulier, la plaque d'habillage peut être une plaque multiposte comprenant plusieurs ouvertures destinées à accueillir les enjoliveurs de plusieurs appareillages électriques et/ou électroniques ou comprenant une grande ouverture rectangulaire ou oblongue destinée à accueillir lesdits enjoliveurs. Le contour extérieur de la plaque d'habillage peut varier. Il peut être rectangulaire ou circulaire. Le contour de l'ouverture centrale ou des ouvertures intérieures de la plaque d'habillage peut être carré, rectangulaire, oblong. Le galbe de la plaque d'habillage est plus ou moins prononcé. Les fibres de bois de la première feuille formant la face avant de la plaque de finition de la plaque d'habillage sont orientées horizontalement ou verticalement par rapport l'orientation d'utilisation de l'enjoliveur de l'appareillage.

## Revendications

1. Plaque d'habillage (500) galbée pour un appareillage électrique et/ou électronique comprenant une plaque de finition (520) fixée sur une sous-plaque (510) portant des moyens de montage (513,514), dans laquelle la plaque de finition (520) présente une forme massive galbée obtenue par moulage sous pression et sous chaleur d'un sandwich d'au moins trois feuilles de bois (523,525,527) de faible épaisseur comprise entre 0,4 et 1 mm, superposées et de couches de colle (524,526) insérées entre les feuilles de bois, lesdites feuilles de bois (523,525,527) étant orientées de sorte que les fibres de bois de deux feuilles immédiatement superposées sont orientées perpendiculairement les unes aux autres, et un bord intérieur (520B) délimitant au moins une ouverture ainsi qu'un bord extérieur périphérique (520A) obtenus par des opérations de découpe.

2. Plaque d'habillage (500) selon la revendication 1, dans laquelle chaque feuille de bois (523,525,527) est une feuille de bois naturel.

3. Plaque d'habillage (500) selon l'une des revendications 1 et 2, dans laquelle chaque couche de colle (524,526) est une couche de colle à bois.

4. Plaque d'habillage (500) selon la revendication 3, dans laquelle la colle à bois est une colle pour usage en extérieur.

5. Plaque d'habillage (500) selon l'une des revendications précédentes, dans laquelle toutes les feuilles de bois (523,525,527) présentent une épaisseur identique.

6. Plaque d'habillage (500) selon la revendication précédente, dans laquelle l'épaisseur de chaque feuille de bois (523,525,527) est de l'ordre de 0,5 millimètre.

7. Plaque d'habillage (500) selon l'une des revendications précédentes, dans laquelle la plaque de finition (520) présente une épaisseur inférieure ou égale à 3 millimètres.

8. Plaque d'habillage (500) selon l'une des revendications précédentes, dans laquelle la plaque de finition (520) présente une face avant (521) et une face arrière (522) parallèles, courbées suivant deux directions coplanaires, perpendiculaires.

9. Plaque d'habillage (500) selon l'une des revendications précédentes, dans laquelle la plaque de finition (520) est fixée à la sous-plaque (510) au moyen d'un adhésif double face.

10. Plaque d'habillage (500) selon l'une des revendications précédentes, dans laquelle la sous-plaque (510) est réalisée d'une seule pièce en matière plastique moulée.

11. Appareillage (1) électrique et/ou électronique qui comprend au moins un mécanisme d'appareillage (200) rapporté sur un support d'appareillage (100), un enjoliveur (300) associé au mécanisme d'appareillage (200) et une plaque d'habillage (500) selon l'une des revendications 1 à 10, montée sur le support d'appareillage (100) au moyen desdits moyens de montage (513,514) de la sous-plaque (510) de sorte que ledit enjoliveur (300) émerge en face avant dudit appareillage (1) au travers de ladite ouverture de la plaque de finition (520).
